# EUROPEAN PATENT SPECIFICATION

(11) **EP 4 345 888 B1**
(45) Date of publication and mention of the grant of the patent: **30.07.2025**
(21) Application number: 23198050.9
(22) Date of filing: 18.09.2023
(51) Int. Cl.: H01L 23/433, H01L 23/373, H01L 23/495

(54) **SEMICONDUCTOR PACKAGE**
HALBLEITERGEHÄUSE
BOÎTIER DE SEMI-CONDUCTEUR

(30) Priority: 30.09.2022 CN 202211207987
(43) Date of publication of application: 03.04.2024
(73) Proprietor: Littelfuse Semiconductor (Wuxi) Co., Ltd., Wuxi, Jiangsu 214142 (CN)
(72) Inventor: ZHANG, Lucas, Wuxi, 214142 (CN); GAO, Chao, Wuxi, 214142 (CN); HE, Lei, Wuxi, 214142 (CN)
(74) Representative: Arnold & Siedsma

(56) References cited:
- CN-U- 217 280 758
- US-A1- 2015 214 133
- US-A1- 2019 311 976
- US-A1- 2022 157 686

## Description

### TECHNICAL FIELD

This disclosure relates generally to the field of power discrete semiconductor devices, and in particular, to discrete semiconductor packages, such as, for example, but not limited to, a high reliability discrete semiconductor package.

### BACKGROUND

Packaging an integrated circuit is typically a final stage of a semiconductor device fabrication process. During packaging, a semiconductor die, which represents the core of a semiconductor device, is encased in a housing that protects the die against physical damage and corrosion. For example, semiconductor dies are commonly mounted on a copper substrate, using solder alloy reflow, conductive epoxy, etc. The mounted semiconductor die is often then encapsulated within a plastic or epoxy compound.

A discrete semiconductor is a device specified to perform an elementary electronic function and is not divisible into separate components functional in themselves. Power semiconductors are used as switches or rectifiers in power electronics. Diodes, transistors, thyristors, and rectifiers are examples of discrete power semiconductors. Discrete power semiconductors are found in a variety of different environments, from very low power systems up to very high-power systems. However, conventions discrete semiconductor device and packages suffer from lower performance and reliability, as well as decreased heat dissipation. US 2015/214133 A1 discloses an apparatus with a chip assembly pad, a semiconductor chip, a clip with a chip linker on the chip and a heat dissipation block on the chip linker, all but the latter encapsulated in a housing.

CN 217 280 758 U discloses a similar apparatus with no heat dissipation block on the chip linker.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

In some implementations, the current subject matter relates to a discrete semiconductor packaging structure. The structure includes a housing, a chip assembly pad being encapsulated by the housing, where the chip assembly pad may be configured for coupling to a semiconductor chip, one or more leads, at least partially encapsulated by the housing, a clip including one or more terminals and a chip linker, where the terminals may be configured for coupling to the one or more leads, and a heat dissipation block, where the chip linker is coupled between the semiconductor chip and the heat dissipation block. The heat dissipation block is configured for removing heat from the semiconductor chip during operation.

In some implementations, the current subject matter may include one or more of the following optional features. The structure may include a heatsink coupled to a first surface of the chip assembly pad. The semiconductor chip may be coupled to a second surface of the chip assembly pad, where the second surface may be opposite of the first surface. Upon coupling of the semiconductor chip to the chip assembly pad, the heatsink does not contact the semiconductor chip. The heatsink may include a flange being positioned between the heatsink and the chip assembly pad. At least a portion of the heatsink may be coupled to the housing.

In some implementations, one or more leads may include a first lead being coupled to a first terminal in one or more terminals of the clip, a second lead being coupled to a second terminal in one or more terminals of the clip, and a third lead being coupled to the chip assembly pad. The first lead and second lead may be configured to extend outside of the housing, and the third lead may be encapsulated by the housing.

In some implementations, the heat dissipation block may be manufactured from a conductive material. The conductive material may include at least one of the following: a copper, a copper alloy, a metal, a metal alloy, and any combination thereof. The heat dissipation block may have a predetermined thickness. The heat dissipation block may be configured to remove heat from the semiconductor chip at least during and after application of a load dump pulse to the semiconductor chip. The semiconductor chip may include a working area. The clip may be configured to be coupled to the semiconductor chip working area. The heat dissipation block may be configured to be positioned over the working area of the semiconductor chip.

In some implementations, one or more clip terminals may be configured to include one or more support protrusions extending laterally away from one or more edges of the one or more clip terminals. The clip may be configured to have a curved structure, where at least a portion of the curved structure of the clip may be configured to extend away from the semiconductor chip.

In some implementations, the chip assembly pad may include a moisture groove for removing moisture from the semiconductor chip during operation.

In some implementations, the housing may be manufactured from at least one of the following: an epoxy compound, a plastic, and any combination thereof.

In some implementations, the structure may include a transient voltage suppression device.

In some implementations, the current subject matter relates to a method of manufacturing the above structure. The method includes providing a semiconductor chip;
forming a heatsink having a flange for positioning of the semiconductor chip, the flange being formed on a top surface of the heatsink; coupling the semiconductor chip to the heatsink and the flange using a chip assembly pad, wherein the chip is configured to be positioned on a top surface of the chip assembly pad, the chip assembly pad being configured to be positioned on a top surface of the flange; forming a clip having one or more clip terminals and a chip linker, and coupling the clip to the semiconductor chip using the chip linker; forming one or more leads and coupling the one or more leads to the one or more clip terminals; positioning and coupling a heat dissipation block to a top surface of the chip linker, the heat dissipation block being configured to remove heat from the semiconductor chip during operation; and forming a housing to encapsulate the semiconductor chip, the chip assembly pad, the clip, and at least a portion of the heatsink and/or the flange, and at least a portion of the leads, where at least a portion of one or more of the leads may be configured to extend outside of the housing.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed implementations. In the drawings,
FIGS. 1a-d illustrate an exemplary discrete power semiconductor structure or apparatus for housing a semiconductor chip, according to some implementations of the current subject matter;
FIGS. 2a-c illustrate an exemplary heatsink of the structure shown in FIG. 1, according to some implementations of the current subject matter;
FIGS. 3a-d illustrate an exemplary clip of the structure shown in FIG. 1, according to some implementations of the current subject matter;
FIGS. 4a-b illustrate an exemplary block of the structure shown in FIG. 1, according to some implementations of the current subject matter;
FIG. 5 illustrates an exemplary semiconductor chip; and
FIG. 6 illustrates an exemplary process, according to some implementations of the current subject matter.

The drawings are not necessarily to scale. The drawings are merely representations, not intended to portray specific parameters of the disclosure. The drawings are intended to depict exemplary implementations of the current subject matter, and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings, where implementations of a system and method are shown. The devices, system(s), component(s), etc., may be embodied in many different forms and are not to be construed as being limited to the example implementations set forth herein. Instead, these example implementations are provided so this disclosure will be thorough and complete, and will fully convey the scope of the current subject matter to those skilled in the art.

To address these and potentially other deficiencies of currently available solutions, one or more implementations of the current subject matter relate to methods, systems, articles of manufacture, and the like that can, among other possible advantages, provide a packaging structure for power semiconductor devices that may advantageously be configured to improve dissipation of heat during operation of such devices, as well as increase their performance and reliability.

There are many packages for housing discrete power semiconductors. TO-263 (various implementations of which are available from Littelfuse, Inc., Chicago, Illinois, USA), for example, is a semiconductor package type intended for surface mounting on printed circuit boards (PCBs). The TO-263 satisfies JEDEC (Joint Electron Device Engineering Council) standards, where JEDEC is a global industry standards group for microelectronics. A package characterized by a generally rectangular-cube shape, the TO-263 has a flat heat sink on its bottom side, with the leads (terminals) being bent to lie against the surface of the PCB. The TO-263 package also has a large thermal plane in its bottom surface, for connection, along with the leads, to the PCB.

One development direction for discrete power semiconductor packages is higher reliability, especially for automotive and aviation products. Some existing TO-263 packages are designed for commercial applications, such as, for example, automotive and aviation applications. The packages may be used for providing passenger safety, power management and subsystem protection that can prevent downstream damage from high energy transient pulses. Such high-energy transient pulses may be referred to as load-dump pulses. Some transient voltage suppressor (TVS) devices may be applied to mitigate damages from the load-dump pules. TO-263 may be surface-mounted and may include TVS devices (e.g., in automotive applications). However, existing TO-263 packages are unable to meet high speed dissipation requirements.

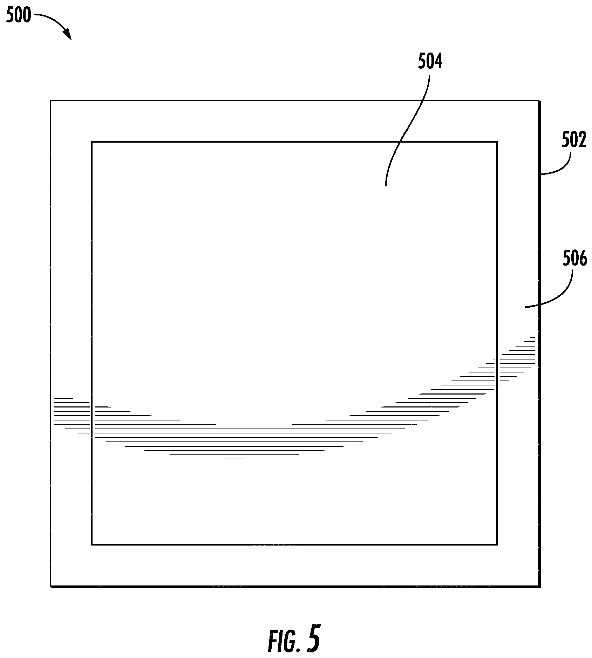

Transient voltage suppressor (TVS) semiconductor devices may be used to protect electronic components from transient voltages, overvoltage, etc. A TVS chip typically serves as a core part for a TVS semiconductor device. As can be understood, any other types of semiconductor chips and/or devices may be used. FIG. 5 illustrates an exemplary semiconductor chip 500. In particular, FIG. 5 illustrates a top view of the semiconductor chip 500.

As shown in FIG. 5, the semiconductor chip 500 may include a chip top portion 502, which may include a chip middle portion and/or working area 504, and a chip border and/or protection area 506. The chip middle portion 504 may be enclosed by the chip border/protection area 506.

The chip 500 may be used in various electronics applications, such as, for example, automotive devices/systems, aviation devices/systems, multi-point data transmission devices, systems, etc., where the chip 500 may be configured as a TVS semiconductor device and/or any other type of semiconductor device. The chip 500 may be used to protect against voltage transients that may be detrimental to operation of various electronic components.

Voltage transients are defined as short duration surges of electrical energy and are the result of the sudden release of energy previously stored and/or induced by other means, such as, for example, heavy inductive loads, lightning, etc. Voltage transients may be classified into predictable or repeatable transients and random transients. In electrical or electronic circuits, this energy can be released in a predictable manner via controlled switching actions, or randomly induced into a circuit from external sources. Repeatable transients are frequently caused by the operation of motors, generators, and/or the switching of reactive circuit components. On the other hand, random transients are often caused by electrostatic discharge (ESD) and lightning, which generally occur unpredictably.

ESD is characterized by very fast rise times and very high peak voltages and currents, which may be the result of an imbalance of positive and negative charges between objects. ESD that is generated by everyday activities can surpass a vulnerability threshold of standard semiconductor technologies. In case of lightning, even though a direct strike is destructive, voltage transients induced by lightning are not the result of a direct strike. When a lightning strike occurs, the event can generate a magnetic field, which, in turn, can induce voltage transients of large magnitude in nearby electrical cables. For example, a cloud-to-cloud strike will affect not only overhead cables, but also buried cables. Even a strike 1 mile distant (1.6km) can generate 50 volts in electrical cables. In a cloud-to-ground strike, the voltage transient generating effect is significantly greater.

In some cases, TVS chips may be packaged using surface mounting packaging, which provides for high power while having an overall small size. For example, SMC packaging may be used in printed circuit boards (PCBs) to protect various electronic components from ESD, electrical fast transients (EFT), lightning, and/or any other transients. SMC packaging allows for surface mounting of electronic components as well as optimization of the space on the PCB (on which such components may be mounted). It may further be characterized by a small profile, improved clamping capability, as well as other enhanced features.

In some implementations, the current subject matter may be configured to provide a high-reliability and performance discrete power semiconductor package or structure that may be configured to include a semiconductor chip mounted on a chip mounting pad positioned above a flange incorporated into a heatsink. This may allow for an improved moisture removal capabilities. The structure may also include a clip coupled to one or more leads and the chip mounting pad. A conductive slug or a block (e.g., copper) or any other heat dissipation device may also be coupled (e.g., using solder) to the clip, where the clip is positioned between the conductive block and a chip linker coupled to the semiconductor chip. Use of the conductive block may be configured to improve absorption of heat from the semiconductor chip during, for example, a load-dump pulse. Further, clip may be coupled to the leads of the structure using solder, rather than, being wire-bound, which may further improve heat dissipation.

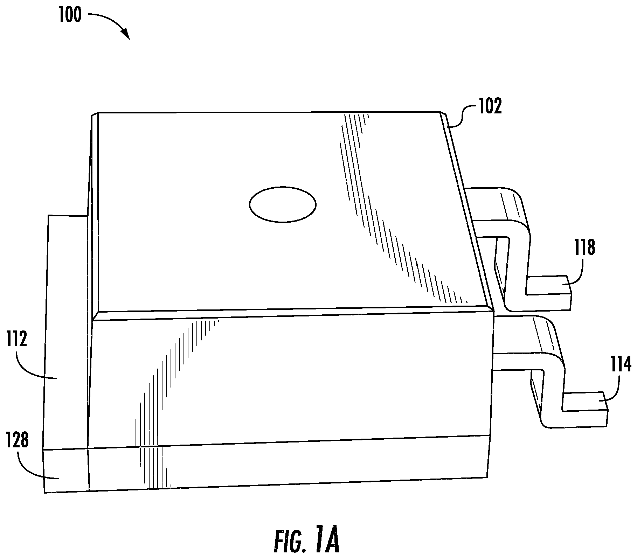

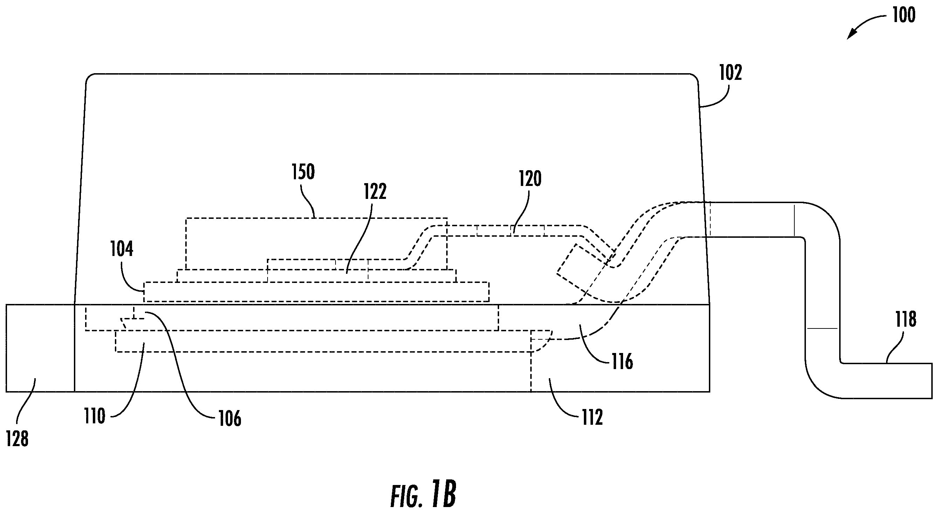

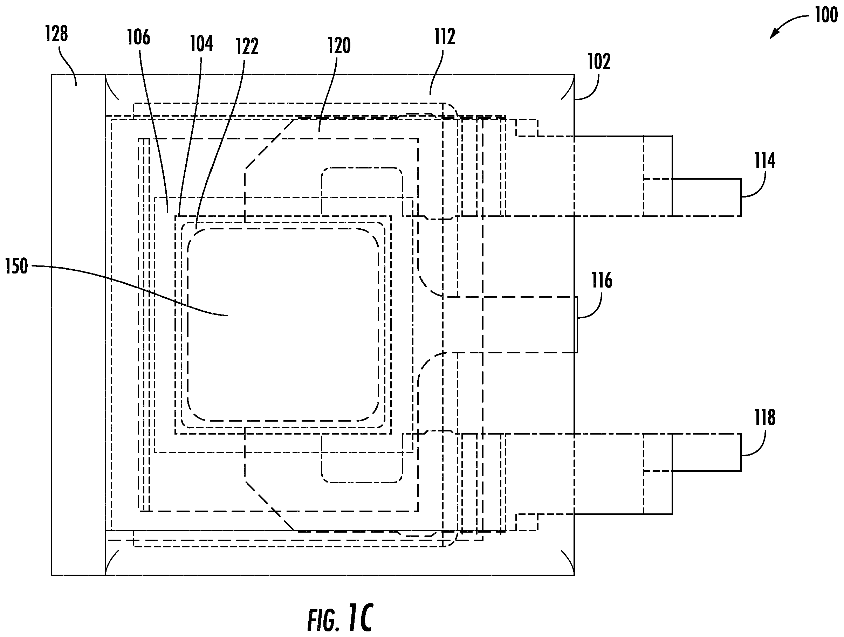

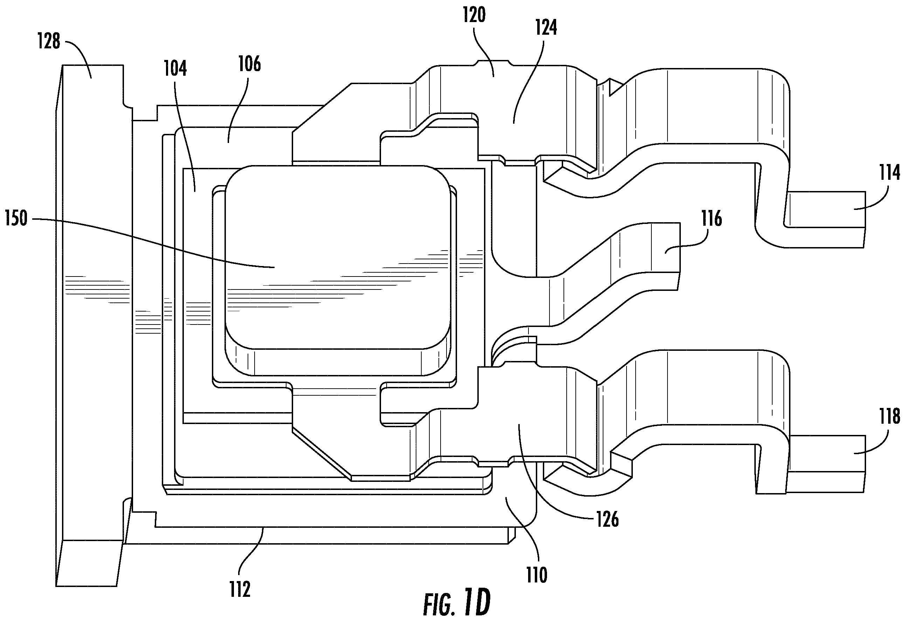

FIGS. 1a-d illustrate an exemplary discrete power semiconductor structure or apparatus 100 for housing a semiconductor chip (as for example shown in FIG. 5), according to some implementations of the current subject matter. FIG. 1a is a perspective view of the structure 100. FIG. 1b is a transparent side view of the structure 100. FIG. 1c is a transparent top view of the structure 100. FIG. 1d is a perspective view of the structure 100 without an encapsulating housing. The structure 100 may, for instance, be a type of TO-263 package. For example, the structure 100 may be configured to house a TVS device (e.g., similar to the one shown in FIG. 5). The structure 100 may be configured to be suitable for either unidirectional and/or bidirectional semiconductor devices.

Referring to FIGS. 1a-d, the structure 100 may be configured to include a housing or an encapsulation 102, a semiconductor chip (e.g., discrete semiconductor chip) 104, a chip mounting pad 106, a flange 110, a heatsink 112, one or more conductive leads (terminals) 114, 116, 118, a clip 120, a chip linker 122, and a heat absorption block or slug 150.

The housing 102 is configured to house and/or encapsulate the chip 104, the chip mounting pad 106, the flange 110, the heatsink 112, at least portions of one or more conductive leads 114, 116, 118, the chip linker 122, and the heat absorption or heat dissipation block 150. The leads 114-118 may be configured to extend from the housing 102 for conductively coupling to other electronic components and/or printed circuit board(s). The housing 102 may be configured to be manufactured from an epoxy compound, a plastic, and/or any other suitable material. In some implementations, the structure 100 may be configured to be positioned on a substrate and/or a printed circuit board (PCB) (not shown in FIGS. 1a-d). The housing 102 of the structure 100 may be configured to provide protection to its encapsulated components from outside stress, e.g., bending, folding, etc. that may cause internal stress, breakage, cracking, etc. to the chip 104. In particular, the housing 102 may also provide protection against mechanical stresses, moisture, dust, debris, etc.

In some implementations, on one side (e.g., bottom side as shown in FIGS. 1a-d), the chip 104 may be configured to be coupled to the chip assembly pad 106. The chip assembly pad 106 may then be coupled to the flange 110, which in turn, may be coupled to the heatsink 112. On the other side (e.g., top side of the chip, as shown in FIGS. 1a-d), the chip 104 may be coupled to the chip linker 122, which, in turn, may be coupled to the clip 120. The block 150 may be configured to be positioned on top of the chip linker 122 and the clip 120, where the block 150 may be coupled to at least one of the chip 104, the chip linker 122 and/or the clip 120. The block 150 may be manufactured from copper, copper alloy, metal, metal alloy, and/or any other suitable material. It, along with the heatsink 112, may be used to aid in heat dissipation during operation of the structure 100 (such as, for example, during occurrence of load-dump pulses). The various couplings between the above components of the structure 100 may be accomplished using solder and/or any other desired techniques.

As stated above, the heatsink 112 may be configured to aid in dissipation of heat away from the semiconductor chip 104. In some implementations, the heatsink 112 may be configured to include a heatsink front support terminal 128 and/or at least portions of one or more of the conductive leads (terminals) 114, 116, and 118. The heatsink front support terminal 128 may be disposed on one side of the heatsink 112 (and thus, the structure 100) and the leads 114-118 may be disposed on the other side, opposite of the heatsink front support terminal 128.

In some implementations, the heatsink 112, the two leads 114, 118, and the end lead 116 may be coupled as a unitary structure. The heatsink 112, the chip assembly pad 106, the heatsink front support terminal 128, and the leads 114-118 may be formed from a single, unitary electrically conductive material, such as, for example, copper, copper alloy, metal, metal alloy, and/or any other suitable materials, and/or any combination thereof. Alternatively, or in addition, the heatsink 112, the chip assembly pad 106, the heatsink front support terminal 128, and the leads 114-118 may be formed from different conductive materials, such as, for example, those listed above. The lead 114 may be a gate terminal; the lead 116 may be a process terminal; and the lead 118 may be an anode terminal. The lead 116 may be coupled to the heatsink 112. The lead 114 and the lead 118 may be coupled to the clip 120 and may be separate from the heatsink 112.

In addition to providing moisture dissipation from the chip 104, the flange 110 and the chip assembly pad 106 may be configured to hold the chip 104 in a predetermined position within the structure 100. In some example, non-limiting implementations, the chip assembly pad 106 may be configured to have a surface area that may be larger than the surface area (e.g., bottom surface area) of the chip 104. The chip assembly pad 106 may be flat and/or may be elevated at its perimeter edge, thereby providing further securing (e.g., in addition to soldering) of the chip 104 in its location. In the latter implementation, such perimeter elevation may also be configured to provide a protective barrier around the chip 104, thereby further aiding in dissipation of moisture from the chip 104.

In some implementations, the clip 120 may include the chip linker 122, a clip terminal 124, and another clip terminal 126. The chip linker 122 may be configured to be disposed over the chip 104. As shown in FIGS. 1a-d, the chip linker 122 may have a rectangular (e.g., square) shape and may be configured to be positioned over a portion of the chip 104. As can be understood, the chip linker 122 may have any desired shape, form, thickness, and/or any other dimensions. The block 150 may be configured to be coupled to the top surface of the chip linker 122 of the clip 120 and the bottom surface of the chip linker 122 may be coupled to the chip 104. The block 150 may have any desired shape, form, thickness and/or any other dimensions. As can be understood, dimensions of any of the components 100 may be so selected as to accommodate a particular implementation and/or use of the structure 100.

The clip terminals 124, 126 of the clip 120 may be disposed on opposite sides of the chip linker 122 and may be aligned for coupling to the terminals 114 and 118. For example, the clip terminal 124 may be configured to be coupled to the terminal 114 and the clip terminal 126 may be configured to be coupled to the terminal 118. As can be understood, any other arrangement of terminals may be possible. The chip linker 122, the clip terminal 124, and the clip terminal 126 may be configured to be formed from a single, unitary electrically conductive material, such as, for example, but not limited to, copper, copper alloy, metal, metal alloy, and any combination thereof. Alternatively, or in addition to, the chip linker 122, the clip terminal 124, and the clip terminal 126 may be configured to be formed from different materials, such as, for example, those that are listed above.

Because of the connection between the terminals 114 and 118 and the respective clip terminals 124 and 126, the clip 120 may be electrically connected to the heatsink 112 as well as the block 150. As stated above, use of the heatsink 112 and the block 150 enhances heat absorption properties of the structure 100, where the block 150 may be configured to absorb heat from the chip 104 (e.g., back of the chip 104) during operations, e.g., such as, during load dump pulse.

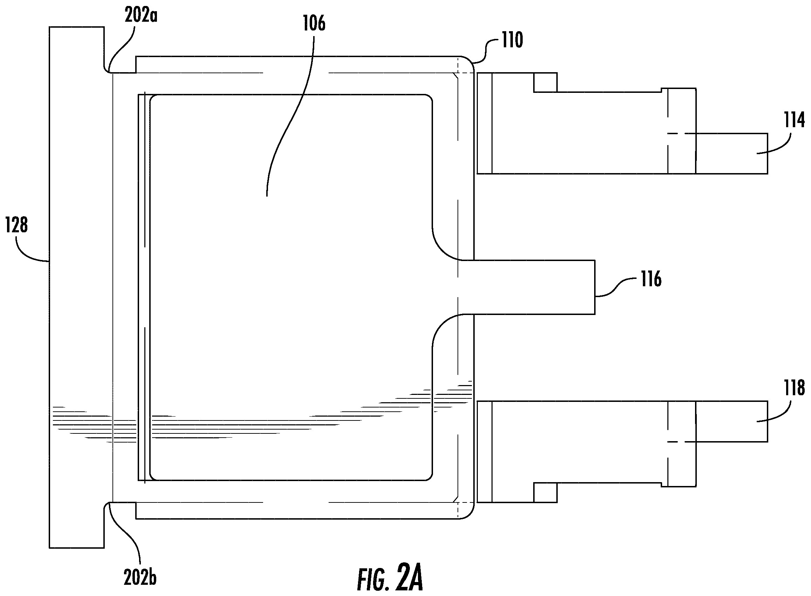

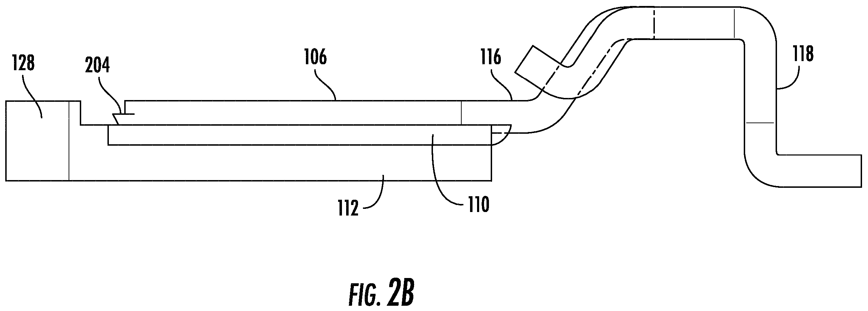

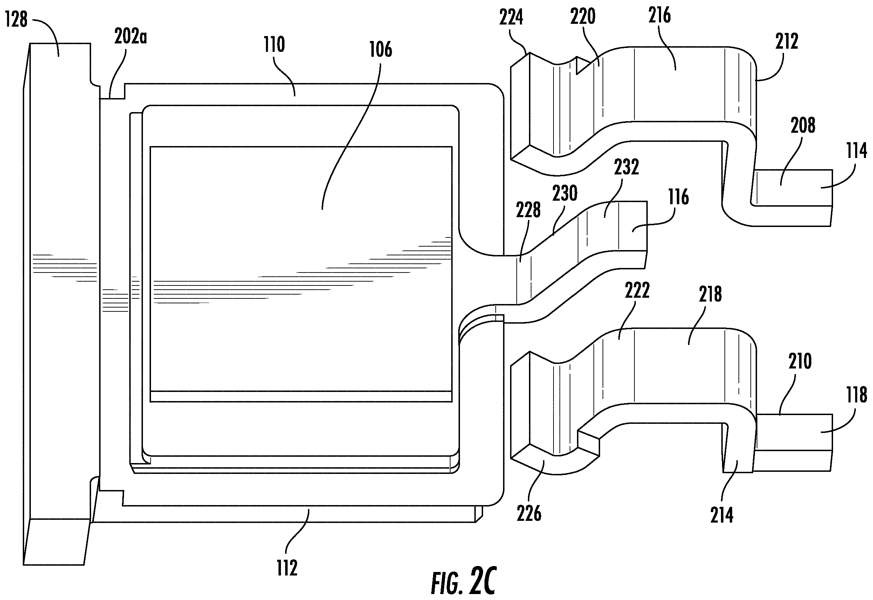

FIGS. 2a-c illustrate the exemplary heatsink 112 of the structure 100, according to some implementations of the current subject matter. In the figures, FIG. 2a is a top view of the heatsink 112; FIG. 2b is a side view of the heatsink 112; and FIG. 2c is a perspective view of the heatsink 112.

As discussed above, the heatsink 112 may be configured to include the heatsink front support terminal 128. The flange 110 may be configured to be positioned on top of the heatsink 112. The chip assembly pad 106 disposed on top of the flange 110 and may be used for positioning of the chip 104 (not shown in FIGS. 2a-c). The flange 112 may include one or more heatsink grooves 202 (a, b). The grooves 202 may be configured to be disposed on two sides of the flange 110 and proximal to the heatsink front support terminal 128. In some exemplary implementations, the grooves 202 may be configured to aid during manufacturing process, such preventing deposition of various compounds between heatsink 112 and other components of the structure 100. Moreover, the chip assembly pad 106 may be configured to include one or more notches 204. The notches 204 may be disposed on a vertical side (e.g., side facing the heatsink front support terminal 128) and/or any and/or all vertical sides of the chip assembly pad 106. The notches 204 may be configured to serve as moisture removal channels that may assist in moisture dissipation during operation of the structure 100 (e.g., removing moisture from the chip 104).

As shown in FIG. 2c, the leads 114, 116, 118 may be configured to have multi-curved shapes. Such shapes may be helpful for coupling/connection of the structure 100 to a substrate, a PCB, and/or any other component. For example, the lead 114 may include an external element connection portion 208 (for coupling to a substrate, PCB, etc., e.g., using soldering), a vertical portion 212 configured to extend away from the portion 208, a horizontal portion 216 configured to lead into the housing 102 (not shown in FIG. 2c), and a curved portion 220 that may be configured to connect to the clip connector 224. The clip connector 224 may be configured for connection to (e.g., using soldering) the clip terminal 124 of the clip 120. In some exemplary implementations, the clip connector 224 may be configured to have a greater width than the width of the portions 208, 212, 216, and 220.

The lead 118 may be configured to be similar to the lead 114 (and may be symmetrically positioned about the lead 116). The lead 118 may include an external element connection portion 210 (for coupling to a substrate, PCB, etc., e.g., using soldering), a vertical portion 214 extending away from the portion 210, a horizontal portion 218 leading into the housing 102 (not shown in FIG. 2c), and a curved portion 222 for connecting to the clip connector 226. The clip connector 226 may be configured to couple (e.g., using soldering) to the clip terminal 126 of the clip 120. Similar to the clip connector 224, the clip connector 226 may be configured to have a greater width than the width of the portions 210, 214, 218, and 222.

The lead 116 may be configured to have an external element connection portion 232, a curved portion 230 and the chip assembly pad connector portion 228. In some exemplary implementations, the portions 228-232 may be configured to have a uniform width and/or varying widths. Moreover, the portions 228-232 may be configured to be disposed inside the housing 102 (not shown in FIG. 2c) in their entireties. Alternatively, or in addition to, one or more of and/or parts of the portions 228-232 may be configured to extend outside of the housing 102. The chip assembly pad 106 and the lead 116 may be configured to form a unitary structure and/or be separate structures that may be coupled together using any desired mechanisms, e.g., solder, welding, etc.

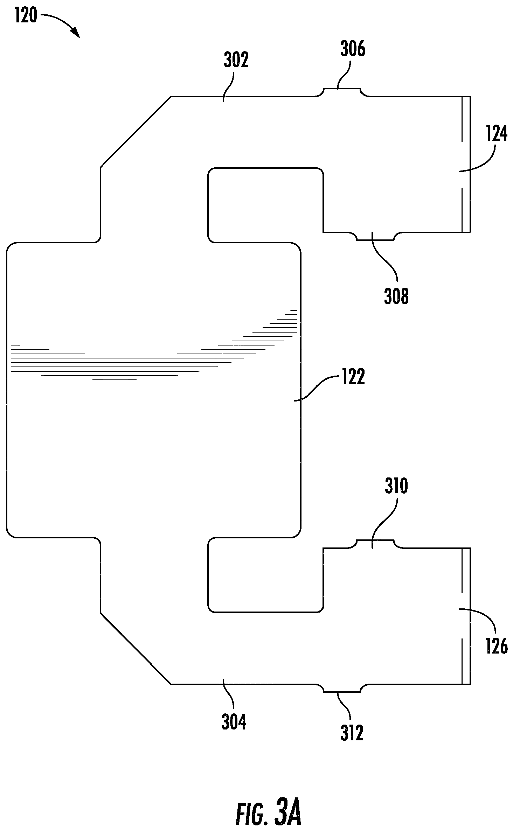

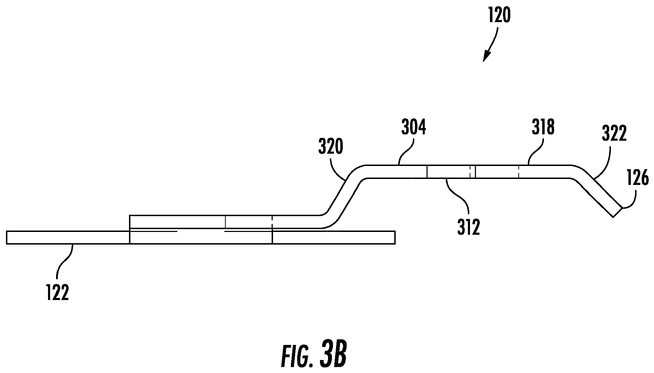

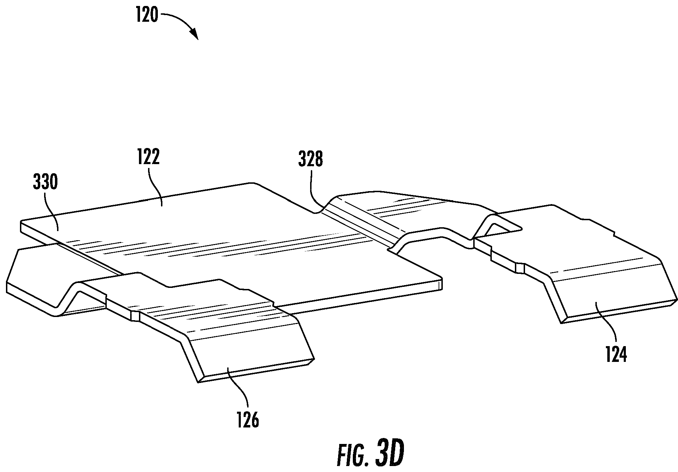

FIGS. 3a-d illustrate the exemplary clip 120 of the structure 100, according to some implementations of the current subject matter. In the figures, FIG. 3a is a top view of the clip 120; FIG. 3b is a side view of the clip 120; FIG. 2c is a perspective view of the clip 120; and FIG. 2d is a back perspective view of the clip 120.

As described above, the clip 120 may be configured to include the chip linker 122 and clip terminals 124, 126. The clip terminal 124 may be coupled to the chip linker 122 using a connector 302, and the clip terminal 126 may be coupled to the chip linker 122 using a connector 304. The connectors 302, 304 may be configured to have a multi-faceted curved form that may be configured for coupling clip terminals 120, 124 to the leads 114, 118, respectively. The chip linker 122 and the clip terminals 124, 126 may be configured to form a unitary structure that may be manufactured from a conductive material, such as, for example, copper, copper alloy, metal, metal alloy, and/or any other suitable materials. Alternatively, or in addition, the chip linker 122 and the clip terminals 124, 126 may be separate components that may be conductively coupled together (e.g., using solder).

In some implementations, the connectors 302, 304 may have a narrower width than the width of the clip terminals 124, 126. Alternatively, or in addition, the connectors 302, 304 and the clip terminals 124, 126 may have a uniform width.

As shown in FIG. 3a, the clip terminal 124 may include protrusions 306, 308 that may be configured to be disposed opposite one another on the clip terminal 124. The protrusions 306, 308 may be configured to extend laterally away from the edges of the clip terminal 124. Similarly, the clip terminal 126 may include protrusions 310, 312 that may be configured to be disposed opposite one another on the clip terminal 126. The protrusions 310, 312 may be configured to extend laterally away from the edges of the clip terminal 126, where protrusion 308 of the clip terminal 124 may be configured to face the protrusion 310 of the clip terminal 126. The protrusions 306-312 may be configured to aid during coupling of the terminals 124, 126 to the leads 114, 118, respectively. Moreover, the protrusions 306-312 may further be configured for supporting positioning of various components of the structure 100 in the housing 102 during manufacturing.

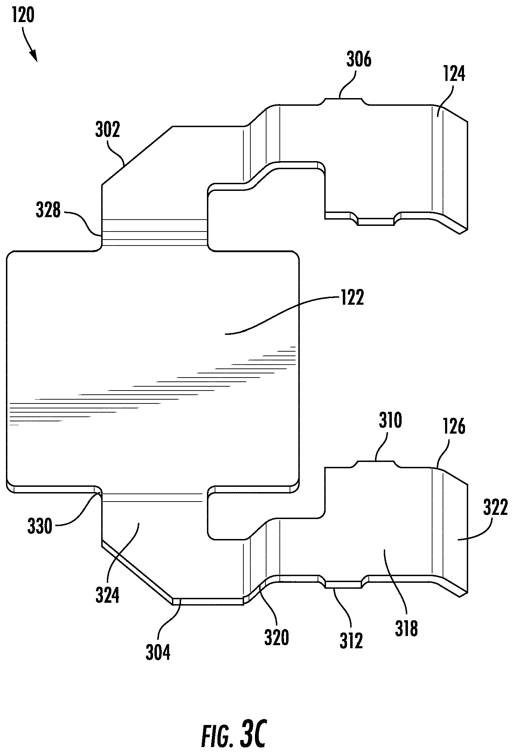

As shown in FIGS. 3b-d, the connector 304 may include a first curved portion 320 that be configured to be bent toward the chip linker 122, a flat portion 318 that may include the protrusion 312 (and protrusion 310 (not shown in FIG. 3b)), and a clip terminal portion 322 that may include the clip terminal 126. The clip terminal portion 322 may be configured to be bent for connection to the lead 118. Another flat portion 324 may be configured to couple the connector 304 to the chip linker 122. A curved section 330 may be disposed as an interlink between the flat portion 324 and the chip linker 122. The structure of the connector 302 (as shown in FIGS. 3a and 3c-d) may be similar to the structure of the connector 304.

As shown in FIGS. 3c-d, the multi-faceted, curved structure of the connectors 302, 304 may allow for the chip linker 122 to be positioned at a lower level as compared to the clip terminals 124, 126. This may allow for an improved coupling of the chip 104 (not shown in FIGS. 3a-d) to the leads 114, 118. It may also provide additional support during manufacturing and/or coupling of the various components of the structure 100. Further, the elevated nature of the connectors 302, 304 may also allow for positioning of the block 150, whose top surface (i.e., surface that is not facing the chip 104) may be level with the connectors 302, 304. Moreover, the elevated nature of the connectors 302, 304 may further aid in dissipation of heat from the chip 104 during operation of the structure 100.

The clip 120 may further be advantageous in that it does not require any wire-bonding of any of the components of structure 100. Instead, various elements of the clip 120 (e.g., terminals 124, 126, chip linker 122, etc.) may be configured to be coupled to other respective components of the structure 100 using solder and/or any other similar techniques. This may further reduce heat buildup, as compared to the existing wire-bonded structures.

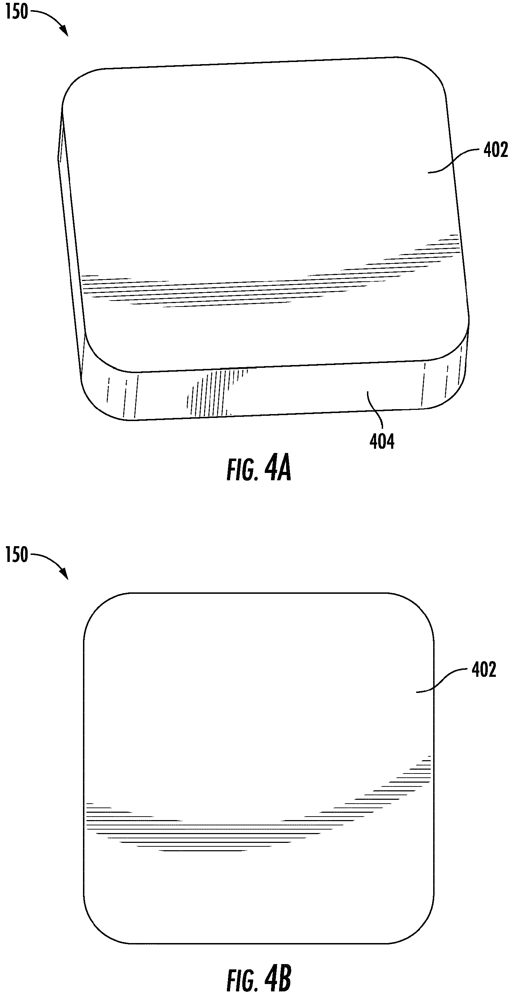

FIGS. 4a-b illustrate the block 150, according to some implementations of the current subject matter. FIG. 4a is a perspective top view of the block 150 and FIG. 4b illustrates a top view of the block 150. As shown, the block 150 may be configured to have a top surface 402 and a side wall 404. The side wall 404 may be configured to have a predetermined height that may be selected for a specific application and/or use of the structure 100. As stated above, the block 150 may be manufactured from any conductive material, such as, for example, copper, copper alloy, metal, metal alloy, and/or any other materials. The block 150 may be configured to absorb heat from the chip 104 during operation of the structure 100.

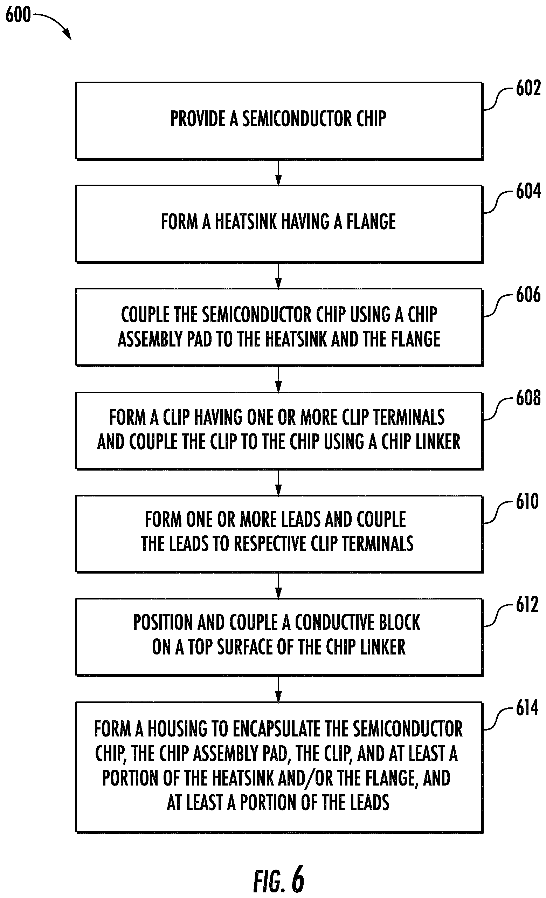

FIG. 6 illustrates an exemplary process 600 for manufacturing and/or manufacturing a packaging structure, according to some implementations of the current subject matter. For example, the packaging structure may be used for packaging a semiconductor chip, such as, for example, a TVS device. The process 600 may be used for manufacturing and/or assembling the structure 100 shown and discussed above in connection with FIGS. 1-4b.

At 602, a semiconductor chip may be provided. For example, the semiconductor chip may be a power semiconductor chip, e.g., rated for 5000 W and/or greater, and/or any other type of chip. The semiconductor chip may have any desired shape, e.g., a rectangular, non-square shape, square shape, etc. An example of such chip is chip 104 shown in FIGS. 1a-b.

At 604, a heatsink having a flange may be formed for positioning of the semiconductor chip. For example, the flange 110 may be formed on a top surface of the heatsink 112.

At 606, the semiconductor chip may be coupled to the heatsink and the flange using a chip assembly pad. As shown in FIGS. 1a-d, the chip 104 may be positioned on a top surface of the chip assembly pad 106, which in turn, may be positioned on a top surface of the flange 110. Soldering may be used to as a coupling mechanism between the above components. A lead 116 may be coupled to the chip assembly pad 106.

At 608, a clip having one or more clip terminals may be formed and coupled to the chip using a chip linker (e.g., chip linker 122). As shown in FIGS. 1a-3d, the clip 120 may include two clip terminals 124, 126 that may be used for connection to the respective leads 114, 118.

At 610, leads 114, 118 may be formed and coupled to the respective clip terminals 124, 126.

At 612, a conductive block (e.g., a heat dissipation device) may be positioned and coupled to a top surface of the chip linker (i.e., a surface that is opposite to a surface coupled to the chip 104). As shown in FIGS. 1a-4b, the block 150 may be used as a heat dissipation mechanism to remove heat from the chip 104 during operation of the structure 100.

At 614, a housing is formed to encapsulate the semiconductor chip, the chip assembly pad, the clip, and at least a portion of the heatsink and/or the flange, and at least a portion of the leads, where at least a portion of one or more of the leads may be configured to extend outside of the housing.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

Some embodiments may be described using the expression "one embodiment" or "an embodiment" along with their derivatives. These terms mean that a particular feature, structure, or characteristic described in connection with the embodiment is included in at least one embodiment. The appearances of the phrase "in one embodiment" (or derivatives thereof) in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

## Claims

1. An apparatus (100), comprising:
a housing (102);
a chip assembly pad (106) being encapsulated by the housing (102), the chip assembly pad (106) being configured for coupling to a semiconductor chip (104);
one or more leads (114, 116, 118), at least partially encapsulated by the housing (102);
a clip (120) including one or more terminals (124, 126) and a chip linker (122), the one or more terminals (124,126) being configured for coupling to the one or more leads (114, 116, 118),; and
a heat dissipation block (150), wherein the chip linker (122) being coupled between the semiconductor chip (104) and the heat dissipation block (150), the heat dissipation block (150) being configured for removing heat from the semiconductor chip (104) during operation,
wherein the housing (102) encapsulates the semiconductor chip (104), the chip assembly pad (106), the clip (120), and the heat dissipation block (150), and at least a portion of the leads (114, 116, 118), where at least a portion of one or more of the leads (114, 116, 118), may be configured to extend outside of the housing.

2. The apparatus according to claim 1, further comprising a heatsink (112) coupled to a first surface of the chip assembly pad (106), wherein the semiconductor chip (104) is being coupled to a second surface of the chip assembly pad (106), the second surface being opposite of the first surface.

3. The apparatus according to claim 2, wherein, upon coupling of the semiconductor chip (104) to the chip assembly pad (106), the heatsink (112) does not contact the semiconductor chip (104).

4. The apparatus according to claim 2 or 3, wherein the heatsink (112) includes a flange (110) being positioned between the heatsink (112) and the chip assembly pac (106).

5. The apparatus according to any of the claims 2-4, wherein at least a portion of the heatsink (112) is coupled to the housing (102).

6. The apparatus according to any of the preceding claims, wherein the one or more leads (114, 116, 118) include
a first lead being coupled to a first terminal in the one or more terminals of the clip (120);
a second lead being coupled to a second terminal in the one or more terminals of the clip (120); and
a third lead being coupled to the chip assembly pad (106), preferably
wherein the first lead and second lead being configured to extend outside of the housing (102) and the third lead being encapsulated by the housing (102);

7. The apparatus according to any of the preceding claims, wherein the heat dissipation block (150) is manufactured from a conductive material, preferably wherein the conductive material includes at least one of the following: a copper, a copper alloy, a metal, a metal alloy, and any combination thereof.

8. The apparatus according to any of the preceding claims, wherein the heat dissipation block (150) has a predetermined thickness, preferably wherein the heat dissipation block (150) is configured to remove heat from the semiconductor chip (104) at least during and after application of a load dump pulse to the semiconductor chip (104).

9. The apparatus according to claim 8, wherein the semiconductor chip (104) includes a working area, preferably wherein the clip (120) is configured to be coupled to the semiconductor chip (104) working area, and/or wherein the heat dissipation block (150) is configured to be positioned over the working area of the semiconductor chip (104).

10. The apparatus according to any of the preceding claims, wherein the one or more clip terminals (124, 126) are configured to include one or more support protrusions (306, 308, 310, 312) extending laterally away from one or more edges of the one or more clip terminals (124, 126) , preferably wherein the clip (120) is configured to have a curved structure, wherein at least a portion of the curved structure of the clip (120) is configured to extend away from the semiconductor chip (104).

11. The apparatus according to any of the preceding claims, wherein the chip assembly pad (106) includes a moisture groove for removing moisture from the semiconductor chip during operation.

12. The apparatus according to any of the preceding claims, wherein the housing (102) is manufactured from at least one of the following: an epoxy compound, a plastic, and any combination thereof.

13. The apparatus according to any of the preceding claims, further comprising a transient voltage suppression device.

14. A method, comprising:
providing a semiconductor chip (104);
forming a heatsink (112) having a flange (110) for positioning of the semiconductor chip, (104), the flange (110) being formed on a top surface of the heatsink (112);
coupling the semiconductor chip (104) to the heatsink (112) and the flange (110) using a chip assembly pad (106), wherein the chip (104) is configured to be positioned on a top surface of the chip assembly pad (106), the chip assembly pad (106) being configured to be positioned on a top surface of the flange (110);
forming a clip (120) having one or more clip terminals (124, 126) and a chip linker (122), and coupling the clip (120) to the semiconductor chip (104) using the chip linker (122);
forming one or more leads (114, 116, 118) and coupling the one or more leads (114, 116, 118) to the one or more clip terminals (124, 126);
positioning and coupling a heat dissipation block (150) to a top surface of the chip linker (122), the heat dissipation block (150) being configured to remove heat from the semiconductor chip (104) during operation; and
forming a housing (102) to encapsulate the semiconductor chip (104), the chip assembly pac (106), the clip, the heat dissipation block (150), and at least a portion of the heatsink (112) and/or the flange (110), and at least a portion of the leads (114, 116, 118) , where at least a portion of one or more of the leads (114, 116, 118) may be configured to extend outside of the housing (102);

15. A discrete semiconductor packaging structure, comprising an apparatus according to any of the preceding claims 1-13.

## Patentansprüche

1. Einrichtung (100), umfassend:
ein Gehäuse (102);
ein Chipmontagepad (106), das durch das Gehäuse (102) eingekapselt ist, wobei das Chipmontagepad (106) konfiguriert ist, um mit einem Halbleiterchip (104) gekoppelt zu sein;
eine oder mehrere Leitungen (114, 116, 118), die mindestens teilweise durch das Gehäuse (102) eingekapselt sind;
einen Clip (120) einschließlich eines oder mehrerer Anschlüsse (124, 126) und eines Chip-Linkers (122), wobei der eine oder die mehreren Anschlüsse (124, 126) zum Koppeln mit der einen oder den mehreren Leitungen (114, 116, 118) konfiguriert sind; und
einen Wärmeableitungsblock (150), wobei der Chip-Linker (122) zwischen dem Halbleiterchip (104) und dem Wärmeableitungsblock (150) gekoppelt ist, wobei der Wärmeableitungsblock (150) zum Ableiten von Wärme vom Halbleiterchip (104) während des Betriebs konfiguriert ist,
wobei das Gehäuse (102) den Halbleiterchip (104), das Chipmontagepad (106), den Clip (120) und den Wärmeableitungsblock (150) sowie mindestens einen Abschnitt der Leitungen (114, 116, 118) einkapselt, wobei mindestens ein Abschnitt einer oder mehrerer der Leitungen (114, 116, 118) konfiguriert sein kann, um aus dem Gehäuse herauszuragen.

2. Einrichtung nach Anspruch 1, ferner umfassend einen Kühlkörper (112), der mit einer ersten Oberfläche des Chipmontagepads (106) gekoppelt ist, wobei der Halbleiterchip (104) mit einer zweiten Oberfläche des Chipmontagepads (106) gekoppelt ist, wobei die zweite Oberfläche der ersten Oberfläche gegenüberliegt.

3. Einrichtung nach Anspruch 2, wobei beim Koppeln des Halbleiterchips (104) mit dem Chipmontagepad (106) der Kühlkörper (112) den Halbleiterchip (104) nicht berührt.

4. Einrichtung nach Anspruch 2 oder 3, wobei der Kühlkörper: (112) einen Flansch (110) einschließt, der zwischen dem Kühlkörper (112) und dem Chipmontagepad (106) positioniert ist.

5. Einrichtung nach einem der Ansprüche 2 bis 4, wobei mindestens ein Abschnitt des Kühlkörpers (112) mit dem Gehäuse (102) gekoppelt ist.

6. Einrichtung nach einem der vorstehenden Ansprüche, wobei die eine oder die mehreren Leitungen (114, 116, 118) einschließen
eine erste Leitung, die mit einem ersten Anschluss in dem einen oder den mehreren Anschlüssen des Clips (120) gekoppelt ist;
eine zweite Leitung, die mit einem zweiten Anschluss in dem einen oder den mehreren Anschlüssen des Clips (120) gekoppelt ist; und
eine dritte Leitung, die mit dem Chipmontagepad (106) gekoppelt ist, wobei
vorzugsweise die erste Leitung und die zweite Leitung konfiguriert sind, um sich außerhalb des Gehäuses (102) zu erstrecken, und die dritte Leitung durch das Gehäuse (102) eingekapselt ist.

7. Einrichtung nach einem der vorstehenden Ansprüche, wobei der Wärmeableitungsblock (150) aus einem leitfähigen Material hergestellt ist, wobei vorzugsweise das leitfähige Material mindestens eines des Folgenden einschließt: ein Kupfer, eine Kupferlegierung, ein Metall, eine Metalllegierung und eine beliebige Kombination davon.

8. Einrichtung nach einem der vorstehenden Ansprüche, wobei der Wärmeableitungsblock (150) eine vorgegebene Dicke aufweist, wobei vorzugsweise der Wärmeableitungsblock (150) konfiguriert ist, um mindestens während und nach dem Anlegen eines Lastabwurfimpulses an den Halbleiterchip (104) Wärme vom Halbleiterchip (104) abzuleiten.

9. Einrichtung nach Anspruch 8, wobei der Halbleiterchip (104) einen Arbeitsbereich einschließt, wobei vorzugsweise der Clip: (120) konfiguriert ist, um mit dem Arbeitsbereich des Halbleiterchips (104) gekoppelt zu sein, und/oder wobei der Wärmeableitungsblock (150) konfiguriert ist, um über dem Arbeitsbereich des Halbleiterchips (104) positioniert zu werden.

10. Einrichtung nach einem der vorstehenden Ansprüche, wobei der eine oder die mehreren Clipanschlüsse (124, 126) konfiguriert sind, um einen oder mehrere Stützvorsprünge (306, 308, 310, 312) einzuschließen, die sich seitlich von einer oder mehreren Kanten des einen oder der mehreren Clipanschlüsse (124, 126) weg erstrecken, wobei vorzugsweise der Clip (120) konfiguriert ist, um eine gekrümmte Struktur aufzuweisen, wobei mindestens ein Abschnitt der gekrümmten Struktur des Clips (120) konfiguriert ist, um sich vom Halbleiterchip (104) weg zu erstrecken.

11. Einrichtung nach einem der vorstehenden Ansprüche, wobei das Chipmontagepad (106) eine Feuchtigkeitsnut zum Entfernen von Feuchtigkeit aus dem Halbleiterchip während des Betriebs einschließt.

12. Einrichtung nach einem der vorstehenden Ansprüche, wobei das Gehäuse (102) aus mindestens einem des Folgenden hergestellt ist: einer Epoxidverbindung, einem Kunststoff und einer beliebigen Kombination davon.

13. Einrichtung nach einem der vorstehenden Ansprüche, ferner umfassend eine Vorrichtung zur Unterdrückung transienter Spannungen.

14. Verfahren, umfassend:
Bereitstellen eines Halbleiterchips (104);
Ausbilden eines Kühlkörpers (112), aufweisend einen Flansch: (110) zum Positionieren des Halbleiterchips (104), wobei der Flansch (110) auf einer oberen Oberfläche des Kühlkörpers (112) ausgebildet ist;
Koppeln des Halbleiterchips (104) mit dem Kühlkörper (112) und dem Flansch (110) unter Verwendung eines Chipmontagepads (106), wobei der Chip (104) konfiguriert ist, um auf einer oberen Oberfläche des Chipmontagepads (106) positioniert zu werden, wobei das Chipmontagepad (106) konfiguriert ist, um auf einer oberen Oberfläche des Flansches (110) positioniert zu werden;
Ausbilden eines Clips (120) mit einem oder mehreren Clipanschlüssen (124, 126) und einem Chip-Linker (122) und Koppeln des Clips (120) mit dem Halbleiterchip (104) unter Verwendung des Chip-Linkers (122);
Ausbilden einer oder mehrerer Leitungen (114, 116, 118) und Koppeln der einen oder der mehreren Leitungen (114, 116, 118) mit dem einen oder den mehreren Clipanschlüssen (124, 126);
Positionieren und Koppeln eines Wärmeableitungsblocks (150) an einer oberen Oberfläche des Chip-Linkers (122), wobei der Wärmeableitungsblock (150) konfiguriert ist, um während des Betriebs Wärme von dem Halbleiterchip (104) abzuleiten; und
Ausbilden eines Gehäuses (102), um den Halbleiterchip (104), das Chipmontagepad (106), den Clip, den Wärmeableitungsblock (150) und mindestens einen Abschnitt des Kühlkörpers (112) und/oder des Flansches (110) sowie mindestens einen Abschnitt der Leitungen (114, 116, 118) einzukapseln, wobei mindestens ein Abschnitt einer oder mehrerer der Leitungen (114, 116, 118) konfiguriert sein kann, um sich außerhalb des Gehäuses (102) zu erstrecken.

15. Separate Halbleiterpaketstruktur, umfassend eine Einrichtung nach einem der vorstehenden Ansprüche 1 bis 13.

## Revendications

1. Appareil (100), comprenant :
un boîtier (102) ;
une pastille d'assemblage de puce (106) encapsulée par le boîtier (102), la pastille d'assemblage de puce (106) étant configurée pour être couplée à une puce semi-conductrice (104) ;
un ou plusieurs fils (114, 116, 118), au moins partiellement encapsulés par le boîtier (102) ;
une attache (120) comportant une ou plusieurs bornes (124, 126) et un connecteur de puce (122), la ou les bornes (124, 126) étant configurées pour être couplées au ou aux fils (114, 116, 118), ; et
un bloc de dissipation thermique (150), dans lequel le connecteur de puce (122) est couplé entre la puce semi-conductrice (104) et le bloc de dissipation thermique (150), le bloc de dissipation thermique (150) étant configuré pour évacuer de la chaleur de la puce semi-conductrice (104) pendant le fonctionnement,
dans lequel le boîtier (102) encapsule la puce semi-conductrice (104), la pastille d'assemblage de puce (106), l'attache (120), et le bloc de dissipation thermique (150), et au moins une partie des fils (114, 116, 118), où au moins une partie d'un ou plusieurs des fils (114, 116, 118), peut être conçue pour s'étendre à l'extérieur du boîtier.

2. Appareil selon la revendication 1, comprenant en outre un dissipateur thermique (112) couplé à une première surface de la pastille d'assemblage de puce (106), dans lequel la puce semi-conductrice (104) est couplée à une seconde surface de la pastille d'assemblage de puce (106), la seconde surface étant opposée à la première surface.

3. Appareil selon la revendication 2, dans lequel, lors du couplage de la puce semi-conductrice (104) à la pastille d'assemblage de puce (106), le dissipateur thermique (112) n'entre pas en contact avec la puce semi-conductrice (104).

4. Appareil selon la revendication 2 ou 3, dans lequel le dissipateur thermique (112) comporte une bride (110) positionnée entre le dissipateur thermique (112) et la pastille d'assemblage de puce (106).

5. Appareil selon l'une quelconque des revendications 2 à 4, dans lequel au moins une partie du dissipateur thermique (112) est couplée au boîtier (102).

6. Appareil selon l'une quelconque des revendications précédentes, dans lequel le ou les fils (114, 116, 118) comportent
un premier fil couplé à une première borne de la ou des bornes de l'attache (120) ;
un deuxième fil couplé à une seconde borne de la ou des bornes de l'attache (120) ; et
un troisième fil couplé à la pastille d'assemblage de puce (106), de préférence
dans lequel le premier fil et le second fil sont conçus pour s'étendre à l'extérieur du boîtier (102), et le troisième fil est encapsulé par le boîtier (102).

7. Appareil selon l'une quelconque des revendications précédentes, dans lequel le bloc de dissipation thermique (150) est fabriqué à partir d'un matériau conducteur, de préférence dans lequel le matériau conducteur comporte au moins l'un de ce qui suit : un cuivre, un alliage de cuivre, un métal, un alliage de métaux, et toute combinaison de ceux-ci.

8. Appareil selon l'une quelconque des revendications précédentes, dans lequel le bloc de dissipation thermique (150) a une épaisseur prédéterminée, de préférence dans lequel le bloc de dissipation thermique (150) est configuré pour évacuer de la chaleur de la puce semi-conductrice (104) au moins pendant et après l'application d'une impulsion de décharge de charge à la puce semi-conductrice (104).

9. Appareil selon la revendication 8, dans lequel la puce semi-conductrice (104) comporte une zone de travail, de préférence dans lequel l'attache (120) est configurée pour être couplée à la zone de travail de la puce semi-conductrice (104), et/ou dans lequel le bloc de dissipation thermique (150) est conçu pour être positionné sur la zone de travail de la puce semi-conductrice (104).

10. Appareil selon l'une quelconque des revendications précédentes, dans lequel la ou les bornes d'attache (124, 126) sont conçues pour inclure une ou plusieurs saillies de support (306, 308, 310, 312) s'étendant latéralement à l'écart d'un ou plusieurs bords de la ou des bornes d'attache (124, 126), de préférence dans lequel l'attache (120) est conçue pour avoir une structure incurvée, dans lequel au moins une partie de la structure incurvée de l'attache (120) est conçue pour s'étendre à l'écart de la puce semi-conductrice (104).

11. Appareil selon l'une quelconque des revendications précédentes, dans lequel la pastille d'assemblage de puce (106) comporte une rainure d'humidité permettant d'évacuer l'humidité de la puce semi-conductrice pendant le fonctionnement.

12. Appareil selon l'une quelconque des revendications précédentes, dans lequel le boîtier (102) est fabriqué à partir d'au moins l'un de ce qui suit : un composé époxy, une matière plastique, et toute combinaison de ceux-ci.

13. Appareil selon l'une quelconque des revendications précédentes, comprenant en outre un dispositif de suppression de tension transitoire.

14. Procédé, comprenant :
la fourniture d'une puce semi-conductrice (104) ;
la formation d'un dissipateur thermique (112) ayant une bride (110) permettant de positionner la puce semi-conductrice (104), la bride (110) étant formée sur une surface supérieure du dissipateur thermique (112) ;
le couplage de la puce semi-conductrice (104) au dissipateur thermique (112) et à la bride (110) à l'aide d'une pastille d'assemblage de puce (106), dans lequel la puce (104) est conçue pour être positionnée sur une surface supérieure de la pastille d'assemblage de puce (106), la pastille d'assemblage de puce (106) étant conçue pour être positionnée sur une surface supérieure de la bride (110) ;
la formation d'une attache (120) ayant une ou plusieurs bornes d'attache (124, 126) et un connecteur de puce (122), et le couplage de l'attache (120) à la puce semi-conductrice (104) à l'aide du connecteur de puce (122) ;
la formation d'un ou plusieurs fils (114, 116, 118) et le couplage du ou des fils (114, 116, 118) à la ou aux bornes d'attache (124, 126) ;
le positionnement et le couplage d'un bloc de dissipation thermique (150) à une surface supérieure du connecteur de puce (122), le bloc de dissipation thermique (150) étant configuré pour évacuer de la chaleur de la puce semi-conductrice (104) pendant le fonctionnement ; et
la formation d'un boîtier (102) pour encapsuler la puce semi-conductrice (104), la pastille d'assemblage de puce (106), l'attache, le bloc de dissipation thermique (150), et au moins une partie du dissipateur thermique (112) et/ou de la bride (110), et au moins une partie des fils (114, 116, 118), où au moins une partie d'un ou plusieurs des fils (114, 116, 118) peut être conçue pour s'étendre à l'extérieur du boîtier (102).

15. Structure de boîtier discret pour semiconducteur, comprenant un appareil selon l'une quelconque des revendications 1 à 13 précédentes.
